(19) Europäisches Patentamt
European Patent Office
Office européen des brevets

(11) **EP 4 625 285 A1**

(12) **EUROPEAN PATENT APPLICATION**

(43) Date of publication:
**01.10.2025  Bulletin 2025/40**

(21) Application number: 24166531.4

(22) Date of filing: **26.03.2024**

(51) International Patent Classification (IPC):
**G06Q 10/0833** (2023.01)      **G08B 1/00** (2006.01)
**G01D 5/20** (2006.01)      **G01R 27/26** (2006.01)
**G08B 13/14** (2006.01)      **G08B 21/24** (2006.01)
**H05K 1/16** (2006.01)

(52) Cooperative Patent Classification (CPC):
**G06Q 10/0833; G06K 7/00; G08B 13/149;**
**H05K 1/165;** G08B 21/0219; G08B 21/0288;
G08B 21/24

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Nagravision Sàrl**
**1033 Cheseaux-sur-Lausanne (CH)**

(72) Inventors:
• **DEPRAZ, Florian**
  **1033 Cheseaux-sur-Lausanne (CH)**
• **PETI-JEAN, Frederic**
  **1033 Cheseaux-sur-Lausanne (CH)**
• **CALVET, Bertrand**
  **1033 Cheseaux-sur-Lausanne (CH)**
• **GIROUX, Erick**
  **1033 Cheseaux-sur-Lausanne (CH)**

(74) Representative: **Novagraaf International SA**
**Chemin de l'Echo 3**
**1213 Onex, Geneva (CH)**

(54) **ASSET TRACKING DEVICE AND SYSTEM**

(57)    The tracking device (100) is configured to be physically associated with an asset (200) and configured to wirelessly communicate with at least one master computing device (400). It comprises:
- an inductor (L1) having an inductance (L) and configured to vary the inductance (L) depending on whether the tracking device (100) is physically associated with the asset (200) or not, and
- a processor (110) configured to detect an inductance variation of the inductor (L1) that is indicative of an event of physically separating the tracking device (100) and the asset (200) and to wirelessly notify said detected event to the master computing device (400).

Fig. 1

EP 4 625 285 A1

**Description**

TECHNICAL FIELD

The present disclosure relates to an asset or object tracking device or tag, particularly to the detection of detachment and/or attachment events between a tracking tag and an asset.

BACKGROUND

Efficient management and location of assets or objects within various industries remain a significant challenge. For instance, automobile dealerships or car rental companies require an effective system to organize and swiftly pinpoint the location of car keys for an extensive fleet of vehicles. Traditional methods for key management often rely on manual logs or electronic systems that do not provide immediate updates or indicate the status of key-tag associations. The ability to quickly and accurately determine the location of an asset (e.g., a car key) is essential in environments where efficiency and security are of high importance. Existing systems often involve tags that emit radio signals, which can be detected by nearby devices to estimate the proximity of the tagged asset. These systems frequently lack a mechanism to verify the actual physical association of the tag with the asset, leading to potential errors in asset's location when the tag becomes separated.

Moreover, current solutions are not capable of detecting the precise moment when a tag is either attached to or separated from an asset. This drawback is particularly problematic in situations where the integrity of the asset-tag physical association, or attachment, is necessary for operational success. For example, when a car's key is misplaced or changes hands, knowing the last known location and association status of the key is important.

An object of the present invention is to improve the situation, in particular to allow detection of detachment events between tags and assets so as to improve the security and operational efficiency of asset management system.

SUMMARY

The scope of protection is set out by the independent claims. The embodiments, examples and features, if any, described in this specification that do not fall under the scope of the protection are to be interpreted as examples useful for understanding the various embodiments or examples that fall under the scope of protection.

According to a first aspect, a tracking device is configured to be physically associated with an asset and configured to wirelessly communicate with at least one master computing device, and includes:

- an inductor having an inductance and configured to vary the inductance depending on whether the tracking device is physically associated with the asset or not, and
- a processor configured to detect an inductance variation of the inductor that is indicative of an event of physically separating the tracking device and the asset and to wirelessly notify said detected event to the master computing device.

The tracking device is provided with an inductor having an inductance that can vary depending on whether the tracking device is physically associated with the asset or not. The processor of the tracking device can monitor the inductance of the inductor, and detection of a detachment event between the tracking device and the asset can be simply and reliably achieved through detection of a variation of the inductance of the inductor. Then, the tracking device can notify the detachment event to another device, or master computing device, through a wireless transmission.

The processor may be further configured to detect an inductance variation of the inductor that is indicative of an event of physically associating the tracking device and the asset and to wirelessly notify said detected event to the master computing device.

In an embodiment, the tracking device is provided with a through hole for receiving a metal chain, such as a keychain or keyring, for physically associating the tracking device and the asset, and the inductor includes a coil surrounding the through hole.

The inductor may include a coil-shaped metal wire surrounding the through hole provided in the tracking device. In this way, the introduction of the metal chain, or metal key ring, in the through hole or removal of the metal chain from the through hole causes a variation of the inductance of the inductor.

In an embodiment, the tracking device may include a printed circuit board and the coil may be printed on the printed circuit board.

In an embodiment, the tracking device comprises a circuit including the inductor and configured to output an electrical signal to the processor, and the processor is configured to measure a parameter of said electrical signal and to detect a variation of said measured parameters that shows a variation of the inductance of the inductor.

In an embodiment, the tracking device comprises

a resonant circuit, said resonant circuit including the inductor and having a resonant frequency depending on the inductance of the inductor; and
a driver circuit configured to excite the resonant circuit;
wherein the processor is configured to measure the resonant frequency of the resonant circuit and to detect a variation of the measured resonant frequency that shows a variation of the inductance of the inductor.

The processor may be configured to determine that the resonant frequency varies between a first predetermined resonant frequency, that is based on a first inductance of the inductor when the tracking device is physically associated with the asset, and a second predetermined resonant frequency, that is based on a second inductance of the inductor when the tracking device is not physically associated with the asset.

In this way, a detachment, or attachment, event between the tracking device and the asset can be detected by monitoring the resonant frequency of the resonant circuit. For example, if the resonant frequency changes from the first predetermined resonant frequency to the second predetermined resonant frequency, the processor detects a detachment event.

Advantageously, the driver circuit includes a digital inverter having an input terminal and an output terminal respectively connected to two terminals of the inductor.

In another embodiment, the tracking device comprises

> a RL circuit including the inductor and a resistor connected in series to the inductor; and
> a power signal generation circuit configured to generate an oscillating power signal to power the RL circuit;
> wherein the processor is configured to measure an amplitude of an output signal of the RL circuit and to detect a variation of the measured amplitude that shows a variation of the inductance of the inductor.

The processor can be configured to periodically perform measurements to detect the inductance variation, a period between two successive measurements being less than 10 seconds, preferably less than 5 seconds. The period should allow to detect when the asset is detached or unpaired from the tracking device, before a new asset is attached or paired with the tracking device.

Advantageously, the period between two successive measurements is more than 0,5 second. In this way, the measurements are not too frequent, which allows to save battery.

According to another aspect, a system includes

- at least one tracking device as previously defined, configured to be physically associated with an asset, and
- at least one master computing device,

wherein the at least one tracking device and the at least one master computing device are configured to wirelessly communicate with one another.

In an embodiment, the system may include

- an asset management system configured to communicate with the at least one master computing device; and
- a database configured to store, for each asset, identification information of said asset, information on whether said asset is physically associated with a tracking device and, if applicable, identification information of said tracking device physically associated with the asset;

wherein, upon notification of an event of physically separating an asset and a tracking device, the asset management system is configured to update the database.

Advantageously, the database may store, for each asset, location information determined based on radio signals emitted by the tracking device physically associated with said asset to the at least on master computing device.

According to another aspect, a method of monitoring an asset, said asset being configured to be physically associated with a tracking device including an inductor having an inductance and configured to vary the inductance depending on whether the tracking device is physically associated with the asset or not, comprises the steps, performed by the tracking device, of:

- detecting an inductance variation of the inductor that is indicative of an event of physically separating the tracking device and the asset;
- wirelessly notifying said detected event to a master computing device.

The method can further comprise the steps of:

- notifying the detected event to an asset management system that stores in a database, for each asset, identification information of said asset, information on whether said asset is physically associated with a tracking device and, if applicable, identification information of said tracking device physically associated with the asset;
- upon notification of the detected event, updating the database.

BRIEF DESCRIPTION OF THE DRAWINGS

Example embodiments will become more fully understood from the detailed description given herein below and the accompanying drawings, which are given by way of illustration only and thus are not limiting of this disclosure.

> FIG. 1 illustrates a system including an asset physically associated with, or attached to, a tracking device, different master computing devices and an asset management server, according to an embodiment.
> FIG. 2 is a schematic block diagram illustrating a tracking device according to an embodiment.

FIG. 3A and 3B illustrate schematic diagrams of a LC resonant circuit and an excitation or driver circuit of the tracking device of FIG. 2 according to an embodiment.

FIG. 4 is a flowchart diagram illustrating a method of managing an asset, according to an embodiment.

FIG. 5 is a flowchart diagram illustrating a detection process for detecting a detachment or attachment event between a tracking device and an asset, according to an embodiment.

It should be noted that these drawings are intended to illustrate various aspects of devices, methods and structures used in example embodiments described herein. The use of similar or identical reference numbers in the various drawings is intended to indicate the presence of a similar or identical element or feature.

DETAILED DESCRIPTION

Detailed example embodiments are disclosed herein. However, specific structural and/or functional details disclosed herein are merely representative for purposes of describing example embodiments and providing a clear understanding of the underlying principles. However these example embodiments may be practiced without these specific details. These example embodiments may be embodied in many alternate forms, with various modifications, and should not be construed as limited to only the embodiments set forth herein. In addition, the figures and descriptions may have been simplified to illustrate elements and / or aspects that are relevant for a clear understanding of the present invention, while eliminating, for purposes of clarity, many other elements that may be well known in the art or not relevant for the understanding of the invention.

Assets or objects or items, for example vehicle's keys, often involve tracking to determine their location in environments where they may be misplaced or lost. Traditional methods of locating such objects involve attaching a tracking device or tag to the object to locate, said tag being designed to emit a signal to indicate its location or provide other types of information. The tag can wirelessly communicate with a nearby master computing device, such as a smartphone or gateway, to facilitate the location of the tagged object for example through signal triangulation or direct communication. While effective in determining the proximity of the object to the receiving device (e.g., smartphone or gateway), these methods do not provide information about the physical association or pairing between the tag and the object.

Existing solutions face a significant limitation in that they cannot detect the physical state of the tag's attachment to the object. When a tag becomes detached from the object the tag is meant to track, the system might continue to operate under the assumption that the tag is still attached, leading to inaccurate location information of the object or asset. Also, when a tag is detached from a first object and attached to a second object, different from the first object, the system might continue to operate under the assumption that the tag is still attached to the first object, leading to potential errors in identifying and locating the objects. Furthermore, current systems do not account for the energy consumption associated with continuous signal emission, which can lead to premature depletion of the tag's power source or battery.

The present disclosure addresses these challenges by providing a tracking device that is physically associated with (e.g., attached to) an asset and is capable of wirelessly communicating with another computing device, referred as a master computing device. The tracking device includes a circuitry with an inductor designed to vary its inductance based on the physical association with the object, i.e., based on whether or not the tracking device is physically associated with or attached to the object. A processor within the tracking device detects changes in inductance that indicate the physical separation (i.e., detachment) between the tracking device and the object. Upon detecting such an event, the processor wirelessly notifies the master computing device. In an embodiment, the master computing device can notify the detected event to an asset management system. The latter can then update a database storing location and/or tracking information and other types of information related to the object the tracking device is tracking or monitoring. Advantageously, the processor within the tracking device can detect changes in inductance that indicate the physical association (i.e. attachment) between the tracking device and the object. Upon detecting such an event, the processor can wirelessly notify the master computing device. This approach allows for real-time monitoring of the physical connection between the object and the tracking device, enhancing the accuracy of location tracking and providing immediate alerts upon detachment.

Embodiment 1

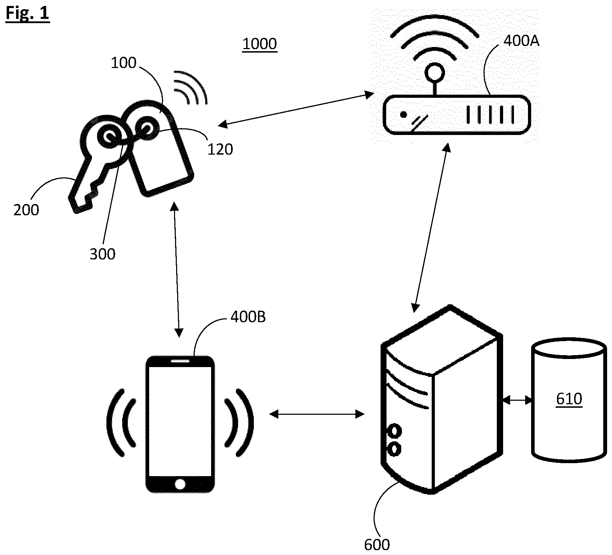

FIG. 1 shows a distributed system 1000 according to a first embodiment or Embodiment 1.

The term "asset" refers to any physical resource or object or item. Examples include keys, such as vehicle's keys, smartphones, equipment, etc.

The distributed system 1000 includes one or more asset tracking devices or tags 100 for tracking assets 200 and one or more other computing devices 400 (for example 400A, 400B, etc.), referred as master computing devices, that are capable of wirelessly communicating with the tracking devices 100.

Optionally, the distributed system 1000 may include an asset management system 600 to which the master computing devices 400 are or can be connected and responsible for tracking or monitoring of the asset(s) 200 through the tracking devices or tags 100 and the master computing devices 400. The tracking or monitoring of an asset 200 refers to collecting data on asset status, location, and/or usage, advantageously in real-time.

A tracking device 100 is configured to be physically associated or paired with an asset or item or object 200. The tracking device 100 may be configured to be attached to the asset 200 for example by means of a metal attach or chain 300, such as a metal ring. In an illustrative and non-limitative example, the asset 200 may be a key (e.g., a vehicle's key) and the tracking device or tag 100 may be in the form of a keyring configured to be attached to the key 200 with a metal ring 300.

The tracking device 100 includes a circuitry with an inductor L1. This circuitry can detect variations in inductance of the inductor L1, which occur in the event the tracking device 100 is either physically associated with or separated from an asset or object 200. This detection is enabled by the presence of the inductor L1 within the tracking device 100, which is sensitive to the proximity of the metal chain or ring 300.

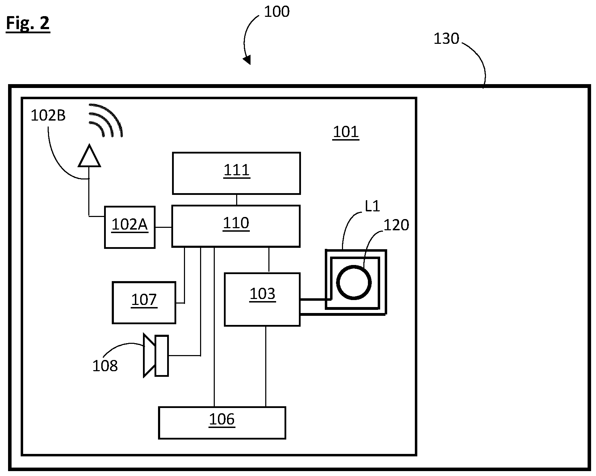

FIG. 2 shows a schematic block diagram of the tracking device 100 according to an embodiment.

The tracking device 100 may include a housing 130 provided with a through hole 120 for receiving the metal attach or chain 300. The tracking device 100 includes internal components and/or the circuitry within the housing 130. These internal components may comprise a wireless communication interface 102A-102B, a detection circuit 103, a battery or power source 106, at least one processor or microprocessor 110, and at least one memory 111.

Optionally, the tracking device 100 may further include one or more other internal components like an accelerometer 107, a loudspeaker 108, one or more sensors, etc.

Optionally, the tracking device 100 may include one or more user interfaces, not represented, connected with the processor 110.

At least part of the internal components of the tracking device 100 may be mounted on a printed circuit board (PCB) 101. The through hole 120 may pass through this printed circuit board 101.

The detection circuit 103 includes the inductor L1. This inductor L1 may include a coil or a coil-shaped wire or a coil-shaped track surrounding the through hole 120 provided in the printed circuit board 101. For example, the coil can be printed on the PCB 101 around the through hole 120 provided in the PCB 101.

The inductor L1 is responsible for the inductance L within the detection circuit 103, which can vary based on the physical association or attachment of the tracking device with the asset 200 the tracking device 100 is monitoring. More precisely, in the present embodiment, the inductance L of the inductor L1 within the detection circuit 103 can vary based on whether a metal chain or ring is introduced in the through hole 120 of the tracking device 100 (to attach the tracking device 100 and the asset 200) or is removed from the through hole 120 (to separate or detach the tracking device 100 and the asset 200).

The detection circuit 103 is configured to output to the processor 110 an electrical signal OUT which allows the processor 110 to:

- detect a change of inductance L of the inductor L1;
- determine if the detected change of inductance is indicative of an detachment event between the tracking device 100 and the asset 200; and
- (optionally) determine if the detected change of inductance is indicative of an attachment event between the tracking device 100 and the asset 200.

Different types of detection circuit 103 can be used to measure a change of inductance. Embodiment 1 is not limited to a specific type of detection circuit 103.

The wireless communication interface 102A allows the tracking device 100 to send and/or receive radio signals. It is connected to the processor 110 and configured to communicate via non wired or wireless communication link(s). It can include or be connected to one or more antenna elements 102B for transmission and/or reception of the radio signals. The wireless communication interface 102A may be configured to wirelessly couple to or communicate with another communicating device (e.g., the master computing devices 400A and/or 400B in FIG. 1). It is arranged to communicate according to one or more types of wireless communication (e.g., protocols). In an embodiment, the wireless communication interface 102A is arranged to communicate according to one or more types of short-range communication such as Bluetooth or Bluetooth Low Energy (BLE). Additionally, or alternatively, the wireless communication circuit 102A may be configured to use Wi-Fi protocols and/or UWB (Ultra-Wide Band) technology to communicate.

The processor 110 is connected to each of the other components 102A, 102B, 103, 107, 108 of the tracking device 100 in order to control operation thereof.

The processor 110 has the role of detecting an inductance variation of the inductor L1 that is indicative of an event of physically separating or physically associating the tracking device 100 and the asset or object 200. It means that the processor 110 can detect a detachment or attachment event between the tracking device 100 and the asset 200 based on a change of inductance of the inductor.

The processor 110 may also be responsible for carrying out a notification operation upon detection detachment or attachment event between the tracking device 100 and the asset 200. The processor 100 may be configured to wirelessly notify the detected event by emitting or broadcasting a radio signal to a master computing device 400.

The memory 111 may be or include a random access memory (RAM), cache memory, non-volatile memory, backup memory (e.g., programmable or flash memories), read-only memory (ROM), or any combination thereof. The ROM of the memory 111 may be configured to store, amongst other things, an operating system of the device 100 and / or one or more computer program code of one or more software applications. The RAM of the memory 111 may be used by the processor 110 for the temporary storage of data.

The processor 110 may be configured to store, read, load, execute and/or otherwise process instructions 111 stored in a computer-readable storage medium and / or in the memory 111 such that, when the instructions are executed by the processor 110, causes the device 100 to perform one or more or all steps of a method described herein for the concerned device 100.

The instructions may correspond to program instructions or computer program code. The instructions may include one or more code segments. A code segment may represent a procedure, function, subprogram, program, routine, subroutine, module, software package, class, or any combination of instructions, data structures or program statements. A code segment may be coupled to another code segment or a hardware circuit by passing and/or receiving information, data, arguments, parameters or memory contents. Information, arguments, parameters, data, etc. may be passed, forwarded, or transmitted via any suitable technique including memory sharing, message passing, token passing, network transmission, etc.

The term "processor" should not be construed to refer exclusively to hardware capable of executing software and may implicitly include one or more processing circuits, whether programmable or not. A processor or likewise a processing circuit may correspond to a digital signal processor (DSP), a network processor, an application specific integrated circuit (ASIC), a field programmable gate array (FPGA), a System-on-Chips (SoC), a Central Processing Unit (CPU), an arithmetic logic unit (ALU), a programmable logic unit (PLU), a processing core, a programmable logic, a microprocessor, a controller, a microcontroller, a microcomputer, a quantum processor, any device capable of responding to and/or executing instructions in a defined manner and/or according to a defined logic.

The battery or power source 106 is configured to power the different elements of the tracking device 100.

The master computing devices 400 may include one or more communicating gateways or access points 400A and/or one or more mobile communication devices 400B (e.g., smartphone(s), tablet(s), etc.).

In an embodiment, the master computing devices 400 can communicate with the asset management system 600.

The asset management system 600 may include at least one computing device such as a server and/or a cloud system. It may comprise or have access to a database 610 storing tracking information (e.g., identification information, location, time, asset status, time, asset usage, associated tracking tag, etc.) related to one or more assets 200. For example, for each of a plurality of registered assets 200, the database 610 may store:

- identification information of said asset 200 (e.g., in case the asset 200 is a vehicle's key, the identification information of the asset 200 may include a vehicle registration number);
- if the asset 200 is attached to or physically associated with a tracking device 100, identification information of the tracking device 100 (e.g., a tag or device identifier such as a Unique Identifier or UID);
- location information indicating where asset 200 is and/or was located ;
- (optional) time information associated with the location information to allow tracking where and when the asset 200 is and/or was located.

The database 610 may only retain the last location information of the asset 200 indicating its last known location. Older location information may be deleted from the database 610.

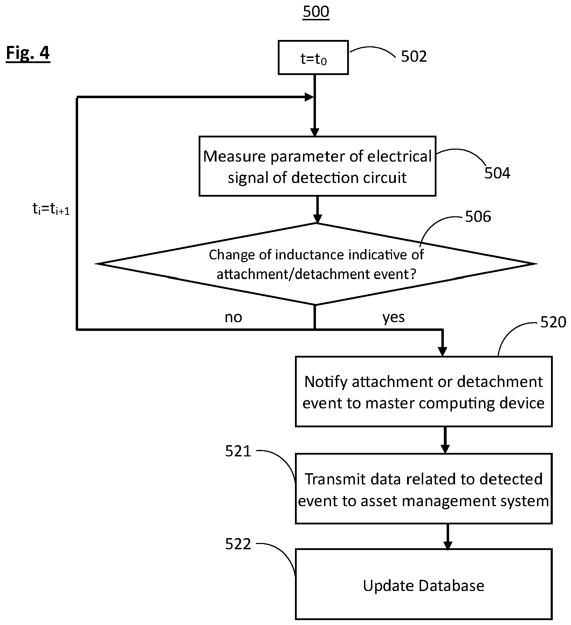

FIG. 4 illustrates a method 500 of monitoring or tracking an asset 200, according to Embodiment 1. This method 500 includes an event detection process of detecting an event of physically separating (i.e., detaching) or an event of physically associating (i.e., attaching together) the asset 200 and a tracking device 100 intended to monitor said asset 200, according to Embodiment 1. The asset 200 is for example a key, such as a vehicle's key.

While the steps are described in a sequential manner, the person skilled in the art will appreciate that some steps may be omitted, combined, performed in different order and / or in parallel.

The method starts at a start time $t=t_0$ with a start step 502. The start step 502 may be carried out when the tracking device 100 intended to monitor the asset 200 is started, for example at the end of manufacturing and/or when it is switched on. After being started and/or powered on, the tracking device 100 could be configured not to turn off unless the battery 106 is discharged.

The start step 502 may initiate the event detection process at time $t=t_0$. In FIG. 4, the block 502 represents the beginning of a cycle where the tracking device 100 starts monitoring at least one parameter of an electrical signal OUT provided by the detection circuit 103 to detect any potential change in inductance L.

Each cycle of the event detection process comprises a step of electrical measurement 504, that can be performed by the processor 110, based on the electrical signal OUT output by the detection circuit 103 including the inductor L1 to the processor 110. The processor 110 may measure a predetermined parameter of the electrical signal OUT. The step 504 is followed by a step 506 of checking if the inductance L of the inductor L1 has changed and, in a positive event (i.e., if the inductance L has changed), if the change of inductance is indicative of an attachment or detachment event between the tracking device 100 and the asset 200.

In the step 506, a change of inductance may be detected by detecting a variation of a value of the parameter of the electrical signal OUT measured in the step 504. A change or variation of the measured parameter shows or indicates or represents a change of inductance L. Such change of inductance may be indicative of an attachment or detachment event between the tracking device 100 and the asset 200 based on whether the measured variation is an increase or a decrease of the parameter value and if the absolute value of this variation is more than a predetermined threshold. The amplitude of change in absolute value, if it is more than the predetermined threshold, is indicative of an attachment or detachment event between the tracking device 100 and the asset 200. The direction of change (increase or decrease) allows to distinguish between an attachment event and a detachment event. Alternatively, the change of inductance is indicative of an attachment or detachment event between the tracking device 100 and the asset 200 if the value of the measured parameter varies from a first predetermined parameter value to a second predetermined parameter value, or vice versa, where one of said predetermined parameter values corresponds to a situation where the tracking device 100 and the asset 200 are attached to one another and the other of said predetermined parameter values corresponds to a situation where the tracking device 100 and the asset 200 are separated or detached. A certain tolerance range around each of the first and second predetermined parameter values may be accepted.

The event detection process including the steps 504 and 506 is periodically executed. A period between two successive measurements 504 may be less than 10 seconds, preferably less than 5 seconds. Optionally, the period may be more than 0,5 second. Advantageously, this period may be adjusted to allow to detect when the asset 200 is detached from the tracking device, before a new object is paired.

If a change of inductance L indicative of an event of attachment (or physical association) or detachment (or physical separation) between the tracking device 100 and the asset 200 is detected in the step 506, the method 500 goes to a step 520 of wirelessly notifying the detected event to a nearby master computing device 400 (e.g., the gateway 400A or the mobile communication device 400B). For that purpose, the tracking device 100 emits or broadcasts a radio signal indicating the detected event (i.e., attachment or detachment event) through its communication interface 102A-102B. The radio signal may include information identifying the tracking device 100, such as a tag identifier (e.g., a tag UID or tag Unique Identifier).

In an embodiment, the master computing device 400 that has been notified of the event detected in the step 506 then notifies this detected event to the asset management system 600. For that purpose, the master computing device 400 can transmit to the asset management system 600 an alert message indicating the detected event and including data related to this detected event, in a step 521. Said data related to the detected event may comprise at least part of :

-    data indicating the detected event (i.e., attachment or detachment event between the tracking device 100 and the asset 200 said tracking device 100 is monitoring),
-    identification information identifying the tracking device 100 (e.g., tag identifier or tag UID), and
-    time information indicating when the detected event occurred or when it was detected.

Furthermore, in a known manner, the asset management system 600 stores and updates the location information of the tracking device 200 in the database 610. For that purpose, the tracking device 100 may periodically emit radio signals, such as beacon signals, to be located for example through signal triangulation or direct communication using these radio signals. The radio signals emitted by the tracking device 100 can be received by one or more nearby master computing devices 400 to estimate the location of the tracking device 100. The radio signals may include the tracking device identifier (e.g., tag UID or tag ID).

The alert message transmitted by the master computing device 400 to the asset management system 600 in the step 521 may optionally include the location information of the tracking device 100.

In all cases, the asset management system 600 regularly updates the database 610 with location information of the tracking device 100 and optionally associates time information to the location information to indicate when the tracking device 100 was located at a given location.

Upon reception of the alert message (step 521), the asset management system 600 may update the database 610 based on the received alert message and information stored in the database 610, as explained below.

If the database 610 stores information that the tracking device 100 identified in the alert message is attached to a given asset 200 (e.g., the identification information or identifier of the tracking device 100 is associated with the identification information or identifier of the asset 200 in the database 610) and the alert message indicates a detachment event between the tracking device 100 and the asset 200, the database 610 may be updated by deleting the identifier of the asset 200 that is associated with the identifier of the tracking device 100 in the database 610. The database 610 may retain historical or past data related to the association between the asset 200 and the tracking device 100, comprising for example information that the asset 200 was previously attached to the tracking device 100, and/or the last known location stored for the tracking device 100 before the detachment event (i.e., when the asset 200 and the tracking device were still attached together) and/or time information on when this last known location was detected. It should be noted that, in this manner, the digital association stored in the database 610 between the tracking device 100 and the asset 200 is updated and can be deleted from the database 610 upon detection of a detachment (or physical separation) event, but the database 610 can keep past information related to this association indicating for example where and when the asset 200 attached to the tracking device 100 was located for the last time. This allows to precisely determine where and when the asset 200 was located just before or when the tracking device 100 and the asset were detached from one another.

Furthermore, the asset management system 600 may generate a message indicating that said asset 200 identified in the database 610 is no longer attached to said tracking device 100. This message may be conveyed to a user or operator, for example by displaying it on a display device of the asset management system 600 or connected to the asset management system 600. Optionally, the asset management system 600 may take any appropriate measure to cope with the detected detachment event between the tracking device 100 and the asset 200 (e.g., by requesting a new attachment between the tracking device 100 and a new asset 200).

If the database 610 does not store information that the tracking device 100 identified in the alert message is attached to an asset 200 (e.g., the identifier of the tracking device 100 is not associated with an asset identifier in the database 610) and the alert message indicates that an attachment event between the tracking device 100 and the asset 200 has been detected, the database 610 may be updated by storing identification information of the asset 200 attached to the tracking device 100. The identification information of said asset 200 may be provided or entered by a user or operator through a user interface upon request of the asset management system 600.

The present method allows to:

- detect an event of physically pairing or attaching together the asset 200 and the tracking device or tag 100, and optionally when and where this event took place; and/or
- detect an event of physically separating or detaching from one another the asset 200 and the tracking device or tag 100, and optionally when and where this event took place;
- store and update in the database 610 location information of the asset 200, status information related to physical pairing or association between the asset 200 and the tag 100 (e.g., if the asset 200 is currently attached to the tracking device 100, when and where the asset 200 was attached to and/or detached from the tracking device 100, etc.).

Embodiment 2

A second embodiment is based on the first embodiment and only differs from it by the features described below.

As previously described, the circuitry of the tracking device 100, more precisely its detection circuit 103, includes the inductor L1.

In Embodiment 2, the detection circuit 103 comprises a resonant circuit 104 and a driver or excitation circuit 105. The resonant circuit 104 may be a LC circuit.

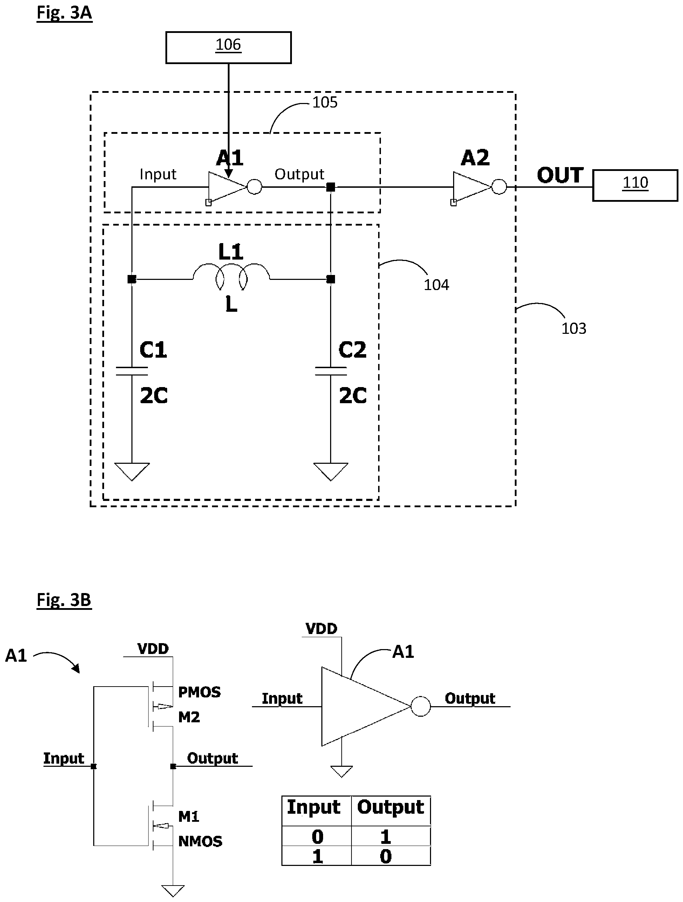

FIG. 3A shows an illustrative and non-limitative example of the resonant circuit 104 that includes the inductor L1 and two capacitors C1, C2. The two terminals of the inductor L1 are respectively connected to terminals of the two capacitors C1, C2. The other terminals of the capacitors C1, C2 are connected to the ground. The inductor L1 has an inductance L, and each of the two capacitors C1, C2 has a capacitance of 2C.

The inductor L1 interacts with the capacitors C1 and C2 to establish the resonant frequency of the circuit. Resonance occurs when the LC circuit 104 is driven or excited from an external source and oscillates at an angular frequency $\omega_0$, namely a resonant frequency, at which the inductive and capacitive reactances are equal in magnitude. The frequency at which this equality holds for the particular circuit represented in FIG. 3A is the resonant frequency. The resonant frequency of the LC circuit shown in figure 3A is $\omega_0 = \frac{1}{\sqrt{LC}}$. The equivalent frequency in units of hertz is $f_0 = \frac{\omega_0}{2\pi} = \frac{1}{2\pi\sqrt{LC}}$.

The resonant circuit 104 is configured to have its resonant frequency $f_0$ that changes when the inductance L of the inductor L1 varies, such as when a metal chain or ring 300 is introduced into or removed from the through hole 120 of the tracking device 100, as will be explained later in the description of the method.

The driver or excitation circuit 105 has the role of exciting the resonant circuit 104 to oscillate at the resonant circuit's resonant frequency. This excitation allows the processor 110 to measure the resonant frequency and detect any changes that indicate the attachment or detachment of the tracking device 100 from the object or asset 200 the device 100 is monitoring.

In an embodiment, the driver 105 may include a digital inverter circuit A1 configured to invert its input signal. In other words, in operation, the output signal of the digital inverter circuit A1 is the inverse of its input signal. As an illustrative and non-limitative example, with reference to FIG. 3B, the digital inverter circuit A1 may include two MOSFETs (Metal-Oxide-Semiconductor Field-Effect Transistor) connected as follows:

- the gate terminals of the two MOSFETs are both connected to the input terminal of the digital inverter circuit A1;

- one of the two MOSFETs has a source terminal provided with a supply voltage $V_{DD}$, for example by the battery 106, and a drain terminal connected to the output terminal of the digital inverter circuit A1;
- the other MOSFET has a drain terminal also connected to the output terminal of the digital inverter circuit A1 and a source terminal connected to the ground.

In operation, for the digital inverter circuit A1, when the input is low (0V or ground), the output is high ($V_{DD}$), and vice versa.

In an embodiment, the input and output terminals of the digital inverter circuit A1 are connected to the two terminals of the inductor L1. This allows to provide the output of the digital inverter circuit A1 to its input through the inductor L1. The digital inverter circuit A1 wants to oscillate as fast as possible, but the LC resonant circuit 104 acts as a filter and fix or set or filter the frequency of oscillation. Without the LC resonant circuit 104, the output of the digital inverter circuit A1 would be a square signal with a very high frequency. The LC resonant circuit 104 transforms this square signal into an oscillating signal of sinusoidal type that oscillates at the resonance frequency $f_0$ imposed by the resonant circuit 105.

Optionally, the tracking device 100 may include another digital inverter circuit A2. The input terminal of the digital inverter circuit A2 may be connected to the output terminal of the digital inverter circuit A1. The output terminal of the digital inverter circuit A2 may be connected to the processor 110 and provide it with an electrical signal OUT, as shown in figure 3A. The role of the digital inverter circuit A2 is to convert the signal provided at the output digital inverter circuit A1 into a digital signal. More precisely, the output signal provided by the output digital inverter circuit A1 may be a hybrid signal (i.e., analog and digital) between an analog sinusoidal signal and a square signal that is considered as a digital signal as it alternates between two levels, high (1) and low (0), with a sudden transition. The digital inverter circuit A2 is responsible for converting this hybrid signal into a digital signal "OUT".

As previously described, the processor 110 is configured to detect a change of inductance L of the inductor L1 and determine if it is indicative of a change of inductance, based on measurements of a parameter of an electrical signal provided by the detection circuit 103. In Embodiment 2, such change of inductance is detected by the processor 110 by detecting a change of the resonant frequency of the resonant circuit 105.

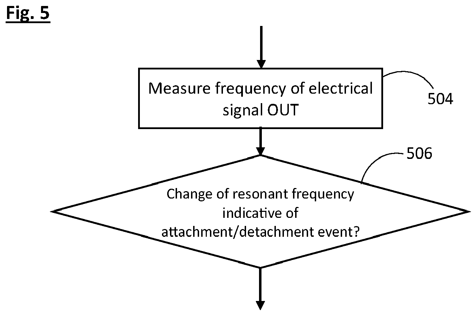

FIG. 5 illustrates the event detection process cyclically executed, according to Embodiment 2. As previously described, the detection process includes the step 504 of measuring a parameter of the electrical signal OUT output from the detection circuit 103 and the step 506 of checking if a change of inductance L indicative of a detachment or attachment event between the tracking device 100 and the asset 200 can be detected.

In Embodiment 2, the step 504 includes measuring a frequency of the electrical signal OUT output from the detection circuit 103. As the resonant circuit 104 is excited by the driver circuit 105, the measured frequency corresponds to the resonant frequency of the resonant circuit 104.

Furthermore, in Embodiment 2, the step 506 includes determining if a change of the resonant frequency can be detected and, in a positive event (i.e., if a change of resonant frequency is detected), if this change is indicative of a detachment or attachment event between the tracking device 100 and the asset 200.

Let's consider that the resonant frequency of the resonant circuit 104 is $f_0$ when the tracking device 100 and the asset 200 are attached to each other by means of a metal chain 300 introduced in the through hole 120, and $f'_0$ when the tracking device 100 and the asset 200 are physically separated, detached from each other, the metal chain being removed from the through hole 120.

These resonant frequencies $f_0$ and $f'_0$ may be predetermined (in other words, determined and known in advance). The resonant frequency $f_0$ is based on a first inductance value L of the inductor L1 when the tracking device 100 is attached to the asset 200. The resonant frequency $f'_0$ is based on a second inductance value L' of the inductor L1 when the tracking device 100 is detached from the asset 200.

In Embodiment 2, in the step 506, the processor 110 may determine if the measured resonant frequency varies from $f_0$ to $f'_0$, or vice versa. In the first case (i.e., if the resonant frequency varies from $f_0$ to $f'_0$), it is determined that the change is indicative of an event of detaching the asset 200 from the tracking device 100. In the second case (i.e., if the resonant frequency varies from $f'_0$ to $f_0$), it is determined that the change is indicative of an event of attaching the asset 200 to the tracking device 100.

In a variant, in the step 506, the processor 110 may determine if the measured resonant frequency decreases or increases and if the absolute value of the variation is above a predetermined threshold, so as to determine if the change of resonant frequence is indicative of a detachment or attachment event between the tracking device 100 and the asset 200. For example, the inductance L of the inductor L1 increases when the metal ring is introduced in the through hole 120.

Embodiment 3

A third embodiment or Embodiment 3 is based on the first embodiment and only differs from it be the features described below.

As previously described, the circuitry of the tracking device 100, more precisely its detection circuit 103, includes the inductor L1.

In Embodiment 3, the detection circuit 103 comprises a RL circuit including the inductor L1 and at least one resistor R1 connected in series with the inductor L1. The RL circuit is configured to be powered by an oscillating power signal, such as an oscillating voltage signal, for example a sinusoidal signal, and to output an output signal OUT to the processor 110. The oscillating power signal can be generated from a constant voltage $V_{batt}$ delivered by the battery 106 through an oscillating power signal generation circuit.

The RL circuit acts as a low-pass filter. When this filter is powered with a given frequency, the change of inductance L affects the amplitude of the output signal OUT.

In operation, in the step 504, the processor 110 measures the amplitude of the output signal OUT of the RL circuit. Then, in the step 506, the processor 110 determines if a change of this amplitude can be detected, which shows a variation of the inductance, and, in a positive event (i.e., if a change of amplitude is detected), if this change is indicative of a detachment or attachment event between the tracking device 100 and the asset 200.

Other Embodiments

There are many variants to measure a change of inductance of the inductor L1 in the circuitry of the tracking device 100. The circuitry may include another combination of components, such as capacitors and/or resistors, in addition to the inductor L1.

It should be appreciated by those skilled in the art that any functions, engines, block diagrams, flow diagrams, state transition diagrams, flowchart and / or data structures described herein represent conceptual views of illustrative circuitry embodying the principles of the invention. Similarly, it will be appreciated that any flow charts, flow diagrams, state transition diagrams, pseudo code, and the like represent various processes.

Although a flow chart may describe a set of steps as a sequential process, many of the steps may be performed in parallel, concurrently or simultaneously. Also some steps may be omitted, combined or performed in different order. A process may be terminated when its steps are completed but may also have additional steps not disclosed in the figure or description.

Each described process, function, engine, block, step described herein can be implemented in hardware, software, firmware, middleware, microcode, or any suitable combination thereof.

As used in this application, the term "circuitry" may refer to one or more or all of the following:

(a) hardware-only circuit implementations (such as implementations in only analog and/or digital circuitry) and

(b) combinations of hardware circuits and software, such as (as applicable) : (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions); and

(c) hardware circuit(s) and or processor(s), such as a microprocessor(s) or a portion of a microprocessor(s), that requires software (e.g., firmware) for operation, but the software may not be present when it is not needed for operation."

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, an integrated circuit for a network element or network node or any other computing device or network device.

The term circuitry may cover digital signal processor (DSP) hardware, network processor, application specific integrated circuit (ASIC), field programmable gate array (FPGA), etc. The circuitry may be or include, for example, hardware, programmable logic, a programmable processor that executes software or firmware, and/or any combination thereof (e.g. a processor, control unit/entity, controller) to execute instructions or software and control transmission and receptions of signals, and a memory to store data and/or instructions.

The circuitry may also make decisions or determinations, generate frames, packets or messages for transmission, decode received frames or messages for further processing, and other tasks or functions described herein. The circuitry may control transmission of signals or messages over a radio network, and may control the reception of signals or messages, etc., via one or more communication networks.

Although the terms first, second, etc. may be used herein to describe various elements, these elements should not be limited by these terms. These terms are only used to distinguish one element from another. For example, a first element could be termed a second element, and similarly, a second element could be termed a first element, without departing from the scope of this disclosure. As used herein, the term "and/or," includes any and all combinations of one or more of the associated listed items.

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

While aspects of the present disclosure have been particularly shown and described with reference to the embodiments above, it will be understood by those skilled in the art that various additional embodiments may be contemplated by the modification of the disclosed devices, systems and methods without departing from the scope of what is disclosed. Such embodiments should be understood to fall within the scope of the present disclosure as determined based upon the claims and any equivalents thereof.

## Claims

1. A tracking device (100) configured to be physically associated with an asset (200) and configured to wirelessly communicate with at least one master computing device (400), said tracking device (100) including:

   - an inductor (L1) having an inductance (L) and configured to vary the inductance (L) depending on whether the tracking device (100) is physically associated with the asset (200) or not, and
   - a processor (110) configured to detect an inductance variation of the inductor (L1) that is indicative of an event of physically separating the tracking device (100) and the asset (200) and to wirelessly notify said detected event to the master computing device (400).

2. The tracking device (100) according to claim 1, wherein the processor is configured to detect an inductance variation of the inductor (L1) that is indicative of an event of physically associating the tracking device (100) and the asset (200) and to wirelessly notify said detected event to the master computing device (400)

3. The tracking device (100) according to claim 1 or 2, wherein

   the tracking device (100) is provided with a through hole (120) for receiving a metal chain (300), such as a keychain or keyring, for physically associating the tracking device (100) and the asset (200), and
   the inductor (L1) includes a coil surrounding the through hole (120).

4. The tracking device according to claim 3, wherein

the tracking device (100) includes a printed circuit board (101) and the coil is printed on the printed circuit board (101).

5. The tracking device according to any of claims 1 to 4, comprising a circuit including the inductor (L1) and configured to output an electrical signal (OUT) to the processor (110), wherein the processor (110) is configured to measure a parameter of said electrical signal and to detect a variation of said measured parameters that shows a variation of the inductance of the inductor (L1).

6. The tracking device according to any of claims 1 to 5, comprising

   a resonant circuit (104), said resonant circuit (104) including the inductor (L1) and having a resonant frequency depending on the inductance (L) of the inductor (L1); and
   a driver circuit (105) configured to excite the resonant circuit (104) ;
   wherein the processor (110) is configured to measure the resonant frequency of the resonant circuit (104) and to detect a variation of the measured resonant frequency that shows a variation of the inductance of the inductor (L1).

7. The tracking device according to claim 6, wherein the processor (110) is configured to determine that the resonant frequency varies between a first predetermined resonant frequency, that is based on a first inductance of the inductor (L1) when the tracking device (100) is physically associated with the asset (200), and a second predetermined resonant frequency, that is based on a second inductance of the inductor (L1) when the tracking device (100) is not physically associated with the asset (200).

8. The tracking device according to any of claims 6 and 7, wherein the driver circuit (105) includes a digital inverter (A1) having an input terminal and an output terminal respectively connected to two terminals of the inductor (L1).

9. The tracking device according to any of claims 1 to 5, comprising

   a RL circuit including the inductor and a resistor connected in series to the inductor; and
   a power signal generation circuit configured to generate an oscillating power signal to power the RL circuit;
   wherein the processor is configured to measure an amplitude of an output signal of the RL circuit and to detect a variation of the measured amplitude that shows a variation of the inductance of the inductor.

**10.** The tracking device according to any of claims 1 to 9, wherein the processor (110) is configured to periodically perform measurements to detect the inductance variation, a period between two successive measurements being less than 10 seconds, preferably less than 5 seconds.

**11.** The tracking device according to claim 10, wherein the period between two successive measurements is more than 0,5 second.

**12.** A system including

- at least one tracking device according to any of claims 1 to 11, configured to be physically associated with an asset (200), and
- at least one master computing device (400),

wherein the at least one tracking device (100) and the at least one master computing device (400) are configured to wirelessly communicate with one another.

**13.** The system according to claim 12, including

- an asset management system (600) configured to communicate with the at least one master computing device (400); and
- a database (610) configured to store, for each asset (200), identification information of said asset (200), information on whether said asset (200) is physically associated with a tracking device (100) and, if applicable, identification information of said tracking device (100) physically associated with the asset (200);

wherein, upon notification of an event of physically separating an asset (200) and a tracking device (100), the asset management system (600) is configured to update the database (610).

**14.** The system according to claim 13, wherein the database (610) stores, for each asset (200), location information determined based on radio signals emitted by the tracking device (200) physically associated with said asset (200) to the at least on master computing device (400).

**15.** A method of monitoring an asset (200), said asset (200) being configured to be physically associated with a tracking device (100) including an inductor (L1) having an inductance (L) and configured to vary the inductance (L) depending on whether the tracking device (100) is physically associated with the asset (200) or not, the method comprising the steps, performed by the tracking device (100), of:

- detecting an inductance variation of the inductor (L1) that is indicative of an event of physically separating the tracking device (100) and the asset (200);
- wirelessly notifying said detected event to a master computing device (400).

**Fig. 1**

**Fig. 2**

## Fig. 3A

## Fig. 3B

| Input | Output |
|-------|--------|
| 0 | 1 |
| 1 | 0 |

**Fig. 4**

500

t=t_0 — 502

Measure parameter of electrical signal of detection circuit — 504

$t_i = t_{i+1}$

Change of inductance indicative of attachment/detachment event? — 506

no          yes

520
Notify attachment or detachment event to master computing device

521 — Transmit data related to detected event to asset management system

522 — Update Database

**Fig. 5**

## EUROPEAN SEARCH REPORT

Europäisches Patentamt
European Patent Office
Office européen des brevets

**Application Number**

EP 24 16 6531

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2004/222889 A1 (HOSHINA MASAKI [JP] ET AL) 11 November 2004 (2004-11-11) <br> * paragraphs [0059], [0081], [0097] * <br> * paragraph [0114] - paragraph [0120] * <br> * figures 1,3,7,8 * | 1-15 | INV. <br> G06Q10/0833 <br> G08B1/00 <br> G01D5/20 <br> G01R27/26 <br> G08B13/14 |
| Y | US 2020/373923 A1 (WALSH PAUL M [IE] ET AL) 26 November 2020 (2020-11-26) | 1-12,15 | G08B21/24 <br> H05K1/16 |
| A | * paragraphs [0016], [0040] - [0049], [0097] * <br> * figure 7 * | 13,14 | |
| Y | US 2021/326807 A1 (HOWELL JAMES PATRICK [CA] ET AL) 21 October 2021 (2021-10-21) | 13,14 | |
| A | * paragraph [0050] - paragraph [0051] * <br> * figure 1 * | 1-12,15 | |

**TECHNICAL FIELDS SEARCHED (IPC)**

G06Q
G08B

The present search report has been drawn up for all claims

| Place of search | Date of completion of the search | Examiner |
|---|---|---|
| Munich | 12 June 2024 | Radovic, Dusica |

EPO FORM 1503 03.82 (P04C01)

## ANNEX TO THE EUROPEAN SEARCH REPORT
## ON EUROPEAN PATENT APPLICATION NO.

EP 24 16 6531

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2024

| Patent document cited in search report | Publication date | Patent family member(s) | | Publication date |
|---|---|---|---|---|
| US 2004222889 A1 | 11-11-2004 | JP | 2004280434 A | 07-10-2004 |
| | | US | 2004222889 A1 | 11-11-2004 |
| | | US | 2007018827 A1 | 25-01-2007 |
| US 2020373923 A1 | 26-11-2020 | DE | 112020002447 T5 | 03-02-2022 |
| | | US | 2020373923 A1 | 26-11-2020 |
| | | US | 2023188135 A1 | 15-06-2023 |
| | | WO | 2020236793 A1 | 26-11-2020 |
| US 2021326807 A1 | 21-10-2021 | EP | 3902291 A1 | 27-10-2021 |
| | | US | 2021326807 A1 | 21-10-2021 |

EPO FORM P0459

For more details about this annex : see Official Journal of the European Patent Office, No. 12/82